Europäisches Patentamt

European Patent Office

Office européen des brevets

(11) Veröffentlichungsnummer: **0 324 067 B1**

# EUROPÄISCHE PATENTSCHRIFT

(45) Veröffentlichungstag der Patentschrift: **19.01.94**

(21) Anmeldenummer: **88117473.4**

(22) Anmeldetag: **20.10.88**

(51) Int. Cl.5: **G01D 3/02**

(54) **Messwertaufnehmer.**

(30) Priorität: **23.12.87 DE 3743846**

(43) Veröffentlichungstag der Anmeldung:
**19.07.89 Patentblatt 89/29**

(45) Bekanntmachung des Hinweises auf die
Patenterteilung:
**19.01.94 Patentblatt 94/03**

(84) Benannte Vertragsstaaten:
**CH DE FR GB IT LI**

(56) Entgegenhaltungen:
**DE-A- 2 841 830**
**DE-A- 3 446 248**

(73) Patentinhaber: **Dr.Ing.h.c. F. Porsche Aktiengesellschaft**
**Porschestrasse 42**
**D-70435 Stuttgart(DE)**

(72) Erfinder: **Pölsler, Wolf-Dieter, Dipl.-Ing.**
**Sperberweg 5**
**D-7251 Weissach(DE)**
Erfinder: **Baumann, Bernd, Dipl.-Ing.**
**Flachter Strasse 59**
**D-7251 Weissach(DE)**

**Beschreibung**

Die Erfindung betrifft einen Meßwertaufnehmer nach dem Oberbegriff des Anspruchs 1.

Bei Meßgeräten oder Meßdatenerfassungs- und -verarbeitungssystemen ist es häufig erforderlich, den Meßwertaufnehmer mit dem eigentlichen physikalisch - elektrischen Wandler, der eine zu erfassende physikalische Größe erfaßt und in ein dazu äquivalentes elektrisches Signal umsetzt, von einer Auswerteschaltung zur Signal-(bzw. Meßwert-)aufbereitung und -verarbeitung räumlich abzusetzen. Meßwertaufnehmer und Auswerteschaltung sind dann in der Regel über elektrische Leitungen miteinander verbunden, wobei die Leitungen selbst über eine Steckverbindung an die Auswerteschaltung angeschlossen sind.

Die Auftrennung von Meßwertaufnehmer und Auswerteschaltung hat häufig räumliche Gründe (um den Meßwertaufnehmer möglichst klein bauen zu können), sie liegt aber auch oft in der "rauhen" Umgebung begründet, in der das Meßgerät betrieben werden soll. Dies sind häufig extrem hohe oder niedrige Temperaturen, Schmutz, Feuchtigkeit, hohe elektromagnetische Strahlung, usw., Bedingungen, unter denen zwar die Meßwertaufnehmer mehr oder weniger perfekt arbeiten können, die Funktionstüchtigkeit einer Auswerteschaltung mit empfindlichen elektronischen Bauteilen jedoch nicht gegeben ist.

Aus der DE-34 46 246 A1 ist ein Meßwertaufnehmer mit einem physikalisch - elektrischen Wandler bekannt, der baulich nicht mit einer Auswerteschaltung vereinigt ist. Der Aufnehmer umfaßt einen Speicherbaustein mit Korrekturdaten für die vom physikalisch - elektrischen Wandler erfaßten Meßwerte. Der physikalisch - elektrische Wandler und der Speicherbaustein sind über wenigstens einen Ausgang mit der Auswerteschaltung verbunden, die die Korrekturdaten aus dem Speicherbaustein auslesen und die vom Wandler gelieferten Meßwerte entsprechend korrigieren kann.

Dieser bekannte Meßwertaufnehmer und das Verfahren zu seinem Abgleich zeigen jedoch lediglich ein Prinzip für die Arbeitsweise eines derartigen Meßsystems auf, geben jedoch keinerlei Hinweis auf eine praktizierbare technische Ausführung. Ein Programmieren des Speicherbausteins mit den Korrekturwerten erfordert zudem ein Anschließen einer Vielzahl von Leitungen (Busanschluß), die nach Fertigstellung des Sensors von außen nicht mehr zugänglich sind, so daß ein "gealterter" Meßwertaufnehmer (d. h., ein Meßwertaufnehmer, der keine korrekten Daten mehr abliefert), nicht mehr rekalibriert werden kann; er muß daher ersetzt werden.

Ebenso geht aus der DE-33 18 977 A1 ein Meßwertaufnehmer mit einem Betriebsdaten enthaltenden Informationsträger (Speichermodul) hervor, bei dem Daten des Speichermoduls entweder über von den Meßleitungen getrennte, mehrere Anschlußleitungen bei Inbetriebnahme ausgelesen und an einen entfernt angeordneten Mikrorechner übertragen werden oder aber das gesamte Speichermodul entnommen und in einen entfernt vom Aufnehmer arbeitenden Verarbeitungsteil eingesetzt werden muß.

Es werden somit entweder mehrere zusätzliche Leitungen vom Aufnehmer zum Verarbeitungsteil notwendig oder ein manueller Arbeitsvorgang, der einerseits umständlich ist, andererseits jedoch häufig zu Beschädigungen der empfindlichen Anschlußkontaktstifte des Speicherbausteins führen kann.

Es ist daher Aufgabe der Erfindung, einen baulich nicht mit einer Auswerteschaltung vereinigten, über elektrische Leitungen an diese angeschlossenen Meßwertaufnehmer mit einem Korrekturdatenspeicherbaustein zu schaffen, bei dem die Korrekturdaten mit einfachen Mitteln weitestgehend über die vorhandenen Leitungen zwischen Meßwertaufnehmer und Auswerteschaltung aktivierbar ausgelesen und zur Korrektur der erfaßten Meßwerte herangezogen werden können.

Die Erfindung ist durch die Merkmale des Anspruchs 1 gelöst. Weitere, die Erfindung in vorteilhafter Weise ausgestaltende Merkmale sind in den Unteransprüchen enthalten.

Die Vorteile der Erfindung sind in erster Linie darin zu sehen, daß ein Meßwertaufnehmer mit einem Korrekturdaten-Speicherbaustein geschaffen wurde, aus dem die Korrekturdaten bei Inbetriebnahme des Meßwertaufnehmers mit einfachen Mitteln ausgelesen werden können. Für diesen Ausleseprozeß werden weitgehend vorhandene, normalerweise der Meßwertübertragung oder der Energieversorgung des Aufnehmers dienende Leitungen verwendet. Die hierfür im Meßwertaufnehmer anzuordnende Schaltung in Form eines Kennungsgebers zeichnet sich durch eine geringe Anzahl von Schaltelementen aus und beeinflußt die Meßwerterfassung im Meßbetrieb in vernachlässigbarer Weise. Der Kennungsgeber zeichnet sich zudem durch einen hohen, für Halbleiter untypischen Betriebstemperaturbereich aus. Durch geringfügige Erweiterung des Kennungsgebers können zusätzlich Daten bei einer Kalibrierung oder Rekalibrierung über die vorhandenen Leitungen von der Auswerteschaltung in den Speicherbaustein des Meßwertaufnehmers eingeschrieben werden.

Ein weiterer Vorteil ergibt sich bei diesem Kennungsgeber durch die Möglichkeit, Betriebsdaten des Meßwertaufnehmers im Speicherbaustein ablegen und auslesen zu können, da der Kennungsgeber völlig unabhängig vom eigentlichen Aufnehmer (physikalisch - elektrischer Wandler) betrieben werden kann.

Mit der Kombination des Meßwertaufnehmers 1 oder 6 und der Auswerteschaltung 3 wird somit ein hochgradig flexibles und bewegliches System gewonnen, da insbesondere

- die Auswerteschaltungen für eine Vielzahl von Typen von Meßwertaufnehmern völlig identisch aufgebaut werden können;
- die Auswerteschaltungen stationär (oder beweglich) aufgebaut und das Meßobjekt völlig unabhängig davon mit Meßwertaufnehmern bestückt werden kann, wobei die Meßwertaufnehmer am Meßobjekt verbleiben und lediglich bei Bedarf an die Meßwertschaltungen angeschlossen werden können (z. B. bei einem Kraftfahrzeug nach Beendigung der Testfahrt)
- beim Auswechseln des physikalisch/elektrischen Wandlers, beispielsweise bei einem Defekt, der Wandler gegen einen anderen mit beispielsweise völlig anderen Betriebsdaten ausgetauscht werden kann, ohne an der Auswerteschaltung etwas ändern zu müssen;
- bei einer Kalibrierung (und beim Meßeinsatz) den Meßwertaufnehmer nicht unbedingt gebunden an eine spezielle Auswerteschaltung betreiben zu müssen, usw.

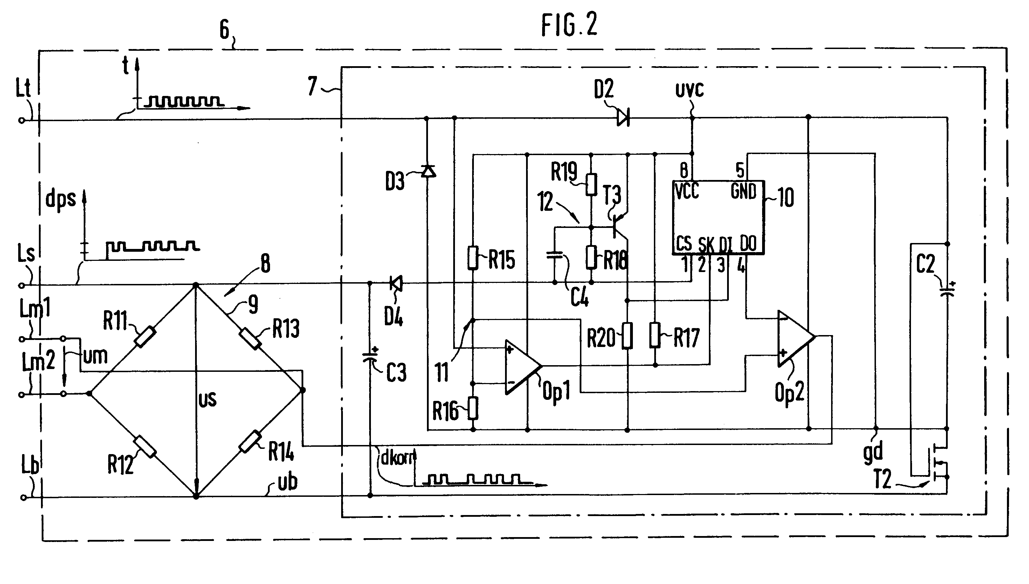

Ein weiterer gewichtiger Vorteil ergibt sich noch im Zusammenhang mit dem Meßwertaufnehmer, wenn die Bausteine des Kennungsgebers entsprechend der in einer zu Fig. 2 genannten Tabelle aufgelisteten Spezifikation gewählt werden: Dann ist nämlich der Kennungsgeber in einem für Halbleiterschaltungen sehr großen Temperaturbereich einsatzfähig, nämlich von -40° C bis +130° C, so daß die Meßwertaufnehmer auch an "heißen" und "kalten" Meßorten verbleiben können.

Die Erfindung wird anhand von in den Zeichnungen dargestellten Beispielen nachstehend näher erläutert.

Es zeigt:

Fig. 1   ein Schaltbild eines Meßwertaufnehmers mit einem Kennungsgeber zum Auslesen von Aufnehmer-Kennungsdaten,

Fig. 2   ein Schaltbild nach Fig. 1, jedoch für einen Meßwertaufnehmer mit Kennungsgeber zum Ein-/Auslesen von Daten mit erhöhtem Temperaturarbeitsbereich,

Fig. 3   ein Schaltbild einer Auswerteschaltung.

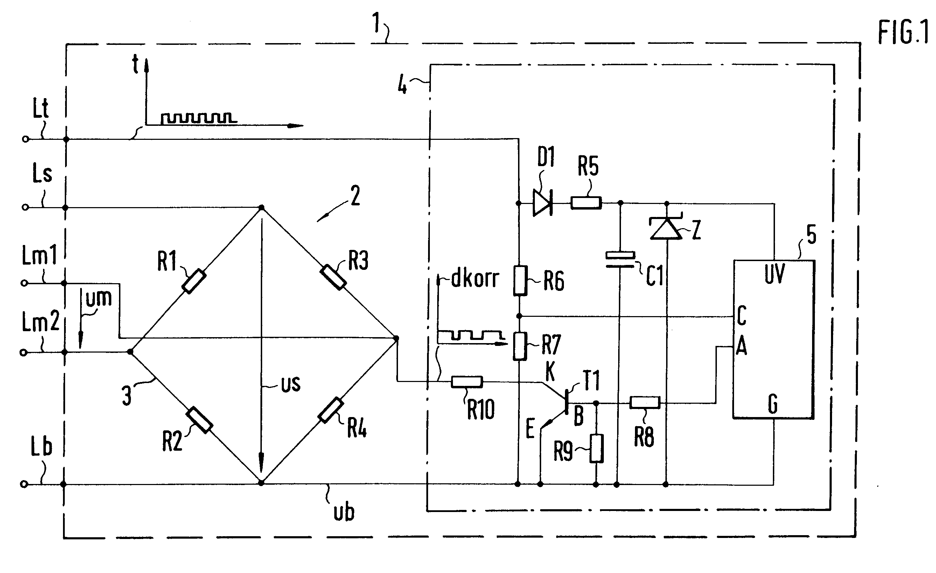

In Fig. 1 ist mit 1 ein Meßwertaufnehmer zur Erfassung einer physikalischen Größe gezeigt. Der Meßwertaufnehmer umfaßt einen physikalisch - elektrischen Wandler 2, beispielsweise einen zu einer Vollbrücke geschalteten Widerstandsmeßgeber 3 mit den veränderlichen Brückenwiderständen R1, R2, R3 und R4. Dies kann beispielsweise ein bekannter Dehnmeßstreifengeber zur Erfassung von Zugspannungen, Drücken (Membrandruckgeber) oder Kräften (Kraftmeßdose) sein.

Die Meßbrücke 3 ist über Leitungen Ls, Lb (zweite Leitung) zur Speisung einer ersten Brückendiagonale (Speisespannung us), d. h., zur Energieversorgung des Meßwertaufnehmers 1, und über Leitungen Lm1 (erste Leitung) und Lm2 zur Abnahme einer Meßspannung um von einer zweiten Brückendiagonalen, mit einer weiter unten beschriebenen Auswerteschaltung 13 verbunden.

Zur Speicherung und Ausgabe von Aufnehmerkennungsdaten, mit denen die vom physikalisch - elektrischen Wandler 2 gelieferten elektrischen Größen, d. h., die über die Leitungen Lm1, Lm2 ausgekoppelte Meßspannung um von statischen und/oder dynamischen Fehlern oder Abweichungen, wie z. B. Nichtlinearitäten, Verstärkungs- und Nullpunktfehlern bereinigt werden kann, ist im Meßwertaufnehmer 1 ein Kennungsgeber 4 angeordnet, der einen seriell auslesbaren, nichtflüchtigen programmier- und löschbaren Speicherbaustein 5 (beispielsweise EPROM, EEPROM) als Bestandteil aufweist.

Der Kennungsgeber 4 ist über die Leitung Lb (Bezugspotential ub), über die Leitung Lm1 (zur Datenausgabe) und über eine weitere Leitung Lt (dritte Leitung) an die Auswerteschaltung 13 angeschlossen. Die Leitung Lt dient der Übermittlung eines Taktsignals t von der Auswerteschaltung 13 zum Kennungsgeber 4. Dieses Taktsignal t wird sowohl zur Initiierung des Ausleseprozesses für die Aufnehmerkennungsdaten aus dem Speicherbaustein 5 sowie zur Lieferung der für den Ausleseprozeß vom Speicherbaustein 5 benötigten Taktinformation (Synchronisation der Datenübertragung) und Energie (Stromversorgung des Kennungsgebers 4) herangezogen.

Zur Stromversorgung des Kennungsgebers 4 wird das Taktsignal t von der Leitung Lt über eine Diode D1 gleichgerichtet und über einen Widerstand R5 und einen gegen Bezugspotential ub geschalteten Kondensator C1 gesiebt. Eine Zehnerdiode Z sorgt für eine notwendige Spannungsbegrenzung der Versorgungsspannung des Speicherbausteins 5 (Eingänge UV, G). Die zum Auslesen der Aufnehmerkennungsdaten benötigte Taktinformation erhält er über einen Eingang C von einem zwischen den Leitungen Lt und Lb liegenden Spannungsteiler aus den Widerständen R6 und R7.

Ein an einem Ausgang A des Speicherbausteins 5 erscheinender serieller Datenbitstrom dkorr der Aufnehmerkennungsdaten wird über einen weiteren Spannungsteiler aus den Widerständen R8, R9 auf die Basis eines Transistors T1 geschaltet, welcher bei positivem Impuls des Datenbitstroms dkorr an der Basis B des Transistors T1 sein Potential am Kollektor K nahezu auf das Potential des Emitters E (Bezugspotenti-

3

al ub) herunterzieht und so einen Widerstand R10 parallel zum Widerstand R4 legt; hierdurch wird die mit der Speisespannung us gespeiste Meßbrücke 3 verstimmt, so daß die Auswerteschaltung 13 eine veränderte Meßspannung um (oder ein verändertes Potential) auf der Leitung Lm1 erfassen und auswerten kann.

Erscheint dagegen ein auf Bezugspotential ub liegender Impuls am Ausgang A des Speicherbausteins 5, so wird der Transistor T1 nicht angesteuert und sein Kollektor-Emitter-Widerstand bleibt hochohmig, so daß der Widerstand R4 (der Meßbrücke 3) nahezu unverändert und somit die Meßbrücke 3 weitgehend unbeeinflußt bleibt; gleiches gilt, wenn das Taktsignal t nach Beendigung der Ausgabe der Aufnehmerkennungsdaten abgeschaltet wird, d.h., der Meßwertaufnehmer 1 in den Meßbetrieb übergeht.

Einen Meßwertaufnehmer 6 mit einem Kennungsgeber 7, welcher sowohl zum Auslesen als auch zum Einlesen von Aufnehmerkennungsdaten geeignet ist, zeigt Fig. 2. Der Meßwertaufnehmer 6 umfaßt in gleicher Weise wie der Meßwertaufnehmer 1 einen physikalisch - elektrischen Wandler 8 in Form einer Meßbrücke 9 mit Widerständen R11, R12, R13, R14 und ist über dieselben Leitungen Lb, Ls, Lm1, Lm2 und Lt an die Auswerteschaltung 13 angeschlossen. Der Kennungsgeber 7 des Meßwertaufnehmers 6 weist jedoch gegenüber dem Kennungsgeber 4 des Meßwertaufnehmers 1 einige Besonderheiten auf. Um nebem dem Auslesen von Aufnehmerkennungsdaten auch (z. B. bei einem Kalibriervorgang) Aufnehmerkennungsdaten in einen Speicherbaustein 10 einlesen zu können, ist der Kennungsgeber 7 zusätzlich zu den Anschlüssen an die Leitungen Lb, Lm1 und Lt an die Leitung Ls (vierte Leitung) angeschlossen, über die ein Anwahlsignal, Chip Select cs, sowie Befehle, Adressen und Daten für den Speicherbaustein 10 in den Kennungsgeber 7 eingelesen werden können; hierzu wird die Leitung Ls von der Auswerteschaltung 13 mit einem sogenannten Drei-Pegel-Signal dps beaufschlagt, wobei

- ein erster logischer Pegel (Null Volt) keiner Ansteuerung,
- ein zweiter logischer Pegel (2,5 Volt) dem Anwahlsignal cs und einer logischen Eins eines Befehls-, Adreß- oder Datenworts und
- ein dritter logischer Pegel (5 Volt) dem Anwahlsignal cs und einer logischen Null eines Befehls-, Adreß- oder Datenworts entspricht.

Das Taktsignal t auf der Leitung Lt dient wiederum der Aktivierung und Stromversorgung des Kennungsgebers 7. Die Stromversorgung erfolgt durch Gleichrichtung des Taktsignals t über zwei Dioden D2 und D3, welche einen Kondensator C2 (zur Glättung) aufladen; an dessen Anschlußfahnen steht dann die Differenz des Versorgungspotentials uvc und des (kennungsgeberinternen) Bezugspotentials gd zur Energieversorgung des Kennungsgebers 7 bereit.

Eine weitere Besonderheit ergibt sich durch den zwischen das kennungsgeberinterne Bezugspotential gd und das Bezugspotential ub des Meßwertaufnehmers 6 geschalteten Feldeffekttransistor T2, der mit seiner Gate-Elektrode auf Versorgungspotential uvc liegt: Er zieht bei Beaufschlagung des Kennungsgebers 7 mit dem Taktsignal t, d. h. mit Aufladen des Kondensators C2, das interne Bezugspotential gd auf das Bezugspotential ub herunter, bei nicht angesteuertem Kennungsgeber 7, d. h. bei abgeschaltetem Taktsignal t (bzw. bei uvc = gd) wird der Feldeffekttransistor T2 dagegen extrem hochohmig, so daß der Widerstand R14 der Meßbrücke 9 und damit die Meßbrücke 9 selbst praktisch unbeeinflußt bleibt.

Der Speicherbaustein 10 ist serielles EEPROM vom Typ NMC9364E und ist über Pin 8 (Eingang VCC) an das Versorgungspotential uvc und über Pin 5 (Eingang GND) an das Bezugspotential gd angeschlossen. Das Anwahlsignal cs, Pin 1 (Eingang CS), wird über einen zwischen die Leitungen Ls und Lb liegenden Kondensator C3 und eine Diode D4 aus dem Dreipegelsignal dps gewonnen. Einem Takteingang SK (Pin 2) des Speicherbausteins 10 wird das über einen Komparator Op1 aufbereitete Taktsignal t der Leitung Lt zugeführt, wobei ein (Schalt-)Bezugspegel auf dem negativen Eingang des als Impulsaufbereitungsschaltung wirkenden Komparators Op1 durch einen zwischen uvc und gd liegenden Spannungsteiler 11 aus den Widerständen R15, R16 erzeugt wird; der Ausgang des Komparators Op1 liegt zudem mit einem Widerstand R17 gegen uvc.

Steuerinformationen, Adressen und Daten werden über eine Trennschaltung 12 aus dem Dreipegelsignal dps gewonnen. Diese bezieht ihre Information über die Diode D4 von der Leitung Ls und koppelt sie über einen gegen uvc geschalteten Spannungsteiler (Widerstände R18, R19) in die Basis eines Transistors T3 ein, wobei parallel zu R18, d. h., zwischen der Diode D4 und der Basis des Transistors T3 ein Kondensator C4 liegt (C4 dient der Verbesserung der Ein- und Ausschaltflanken). Der Kollektor des Transistors T3 schließlich beaufschlagt den Eingang DI (DATA IN), Pin3, des Speicherbausteins 10, wobei der Kollektor über den Widerstand R20 gegen gd und der Emitter des Transistors T3 gegen uvc geschaltet ist.

Der Datenausgang DO (DATA OUT), Pin 4 des Speicherbausteins 10, ist zur Erzeugung des (Aufnehmerkennungsdaten-)Datenbitstroms dkorr auf den negativen Eingang eines weiteren Operationsverstärkers Op2 geschaltet; dessen positiver Eingang liegt am Spannungsteiler 11. Hierdurch kann der Operationsverstärkers Op2 durch den Datenbitstrom dkorr die Leitung Lm1 gegen die Potentiale uvc oder gd legen bzw.

den Brückenzweig mit dem Widerstand R14 im Takte des Datenbitstroms dkorr verstimmen, so daß die Auswerteschaltung 13 daraus die Aufnehmerkennungsdaten detektieren kann.

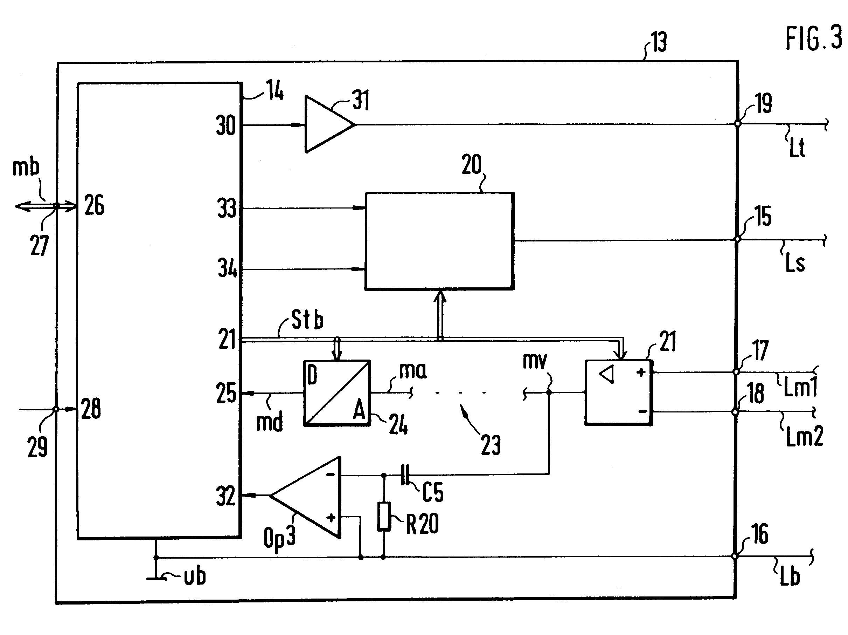

In Fig. 3 schließlich ist eine Auswerteschaltung 13 mit einem Mikrorechner 14 gezeigt. Die Auswerteschaltung 13 weist Steckkontakte 15 und 16 zum Anschluß der Leitungen Ls und Lb (Energieversorgung des Meßwertaufnehmers), Steckkontakte 17 und 18 zum Anschluß der Leitungen Lm1 und Lm2 (Meßwertübertragung) und einen Steckkontakt 19 zum Anschluß der Leitungen Lt (Taktsignal t) auf.

Zur Energieversorgung liegt die Leitung Lb auf Bezugspotential ub (Masse) und die Leitung Ls ist zur Erzeugung der Speisespannung us an ein Stromversorgungsteil 20 angeschlossen, das vorzugsweise vom Mikrorechner 14 (Ausgang 21) aus über einen Steuerbus Stb parametrierbar ist, so daß es aufgabenspezifische, d. h., meßwertaufnehmerabhängige, verschiedene Speisespannungen us erzeugen kann.

Die über die Leitungen Lm1 und Lm2 eingeholte Meßspannung um wird auf einen Instrumentenverstärker 22, der ebenfalls über den Steuerbus Stb parametrierbar (Verstärkungsfaktor und Nullpunkt) sein kann, aufgeschaltet und verstärkt (verstärktes Meßsignal mv). Das verstärkte Meßsignal mv durchläuft den für derartige Meßwertaufnehmer 1; 6 üblichen Analog-Verarbeitungspfad 23 mit (vorzugsweise parametrierbaren) Filtern, Verstärkern usw. (nicht gezeigt) bis zu einem Analog-/Digitalwandler 24, der analoge Signalwerte ma in digitale Werte md umsetzt und über einen Eingang 25 dem Mikrorechner 14 zuführt. Schließlich ist der Mikrorechner 14 (Ein-/Ausgang 26, Anschluß 27) über ein Bussystem mb mit weiteren datenverarbeitenden Geräten oder Ein-/Ausgabe- Geräten und über einen Eingang 28 (Anschluß 29) mit einer externen Stromversorgung verbunden.

Zum Auslesen/Einlesen der Aufnehmerkennungsdaten weist nun die Auswertschaltung 13 einige Besonderheiten auf:

- Über einen Ausgang 30 kann der Mikrorechner 14 das Taktsignal t erzeugen und über einen Verstärker 31 auf die Leitung Lt aufschalten;

- das verstärkte Meßsignal mv am Ausgang des Instrumentenverstärkers 22 wird über einen Kondensator C5 und einen gegen Masse ub liegenden Widerstand R20 auf einen Komparator Op3 geschaltet, der den über die Verstimmung der Meßbrücke 3 bzw. 9 und die Leitungen Lm1 und Lm2 übertragenen Datenbitstroms dkorr mit den seriellen Aufnehmerkennungsdaten des Speicherbausteins 5 bzw. 10 detektiert und aufbereitet einem Eingang 32 des Mikrorechners 14 zuführt;

- das für den Meßwertaufnehmer 6 benötigte Dreipegelsignal dps wird mittels des Stromversorgungsteils 20 erzeugt, das hierzu vom Mikrorechner 14 über einen Ausgang 33 ein Anwahlsignal cs und über einen Ausgang 34 ein Datensignal mit Steuerinformation, Adressen und Daten erhält, addiert und als Dreipegelsignal dps auf die Leitung Ls aufschaltet.

Der Vorgang des Auslesens der Daten läuft folgendermaßen ab:

- Nach Aufstecken der Leitungen Lt, Ls, Lm1, Lm2 und Lb (d. h. des Meßwertaufnehmers 1 oder 6) auf die Auswerteschaltung 13 schaltet diese zunächst das Taktsignal t auf die Leitung Lt auf und aktiviert so gewissermaßen den Ausleseprozeß. Beim Meßwertaufnehmer 6 wird zusätzlich das Dreipegelsignal dps mit einer Steuerinformation "Daten auslesen", gefolgt von einem Datenbitstrom dkorr mit Adressen, unter denen die Aufnehmerkennungsdaten abgelegt sind, auf die Leitung Ls aufgeschaltet.

- Der Meßwertaufnehmer 1; 6 sendet daraufhin über die Leitungen Lm1, Lm2 die Aufnehmerkennungsdaten (im Wechsel mit den von der Auswerteschaltung 13 nach dem vorausgehenden Schritt ausgesendeten Adressen).

- Die Auswerteschaltung nimmt die Aufnehmerkennungsdaten 13, die vorteilhafterweise neben den Aufnehmerkennungsdaten zum Ausgleich von statischen und/oder dynamischen Wandlungseigenschaften des Meßwertaufnehmers 1; 6 oder Teilen der gesamten Auswerteschaltung, wie z. B. Verstärkungs- und Nullpunktfehlern, Nichtlinearitäten usw. auch zusätzlich Betriebsdaten für den Meßwertaufnehmer 1; 6, wie z. B. den Typ, die benötigte Speisespannung us, die Art der Ausgangsdaten, die erfaßten physikalischen Größen, den Meßbereich usw. enthalten, speichert diese zwischen und schaltet nach Aufnahme aller Aufnehmerkennungsdaten das Taktsignal t und das Dreipegelsignal dps ab.

- Daraufhin werden Stromversorgungsteil 20, der Instrumentenverstärker 22, der Analog-verarbeitungspfad 23 und der Analog-/Digitalwandler 24 parametriert, und der Meßbetrieb kann beginnen.

Das Einlesen von Aufnehmerkennungsdaten geschieht auf ähnliche Weise durch Aufschalten des Taktsignals t auf die Leitung Lt und des Dreipegelsignals dps auf die Leitung Ls, wobei hierzu jedoch auf dem Ausgang 34 des Mikrorechners 14 die einzulesenden Daten ausgegeben werden. Der Datenbitstrom dkorr umfaßt hierbei jeweils die Steuerinformation "Daten einlesen", gefolgt von einer Adresse und einem unter dieser abzulegenden Datum. Auf diese Weise sind die Betriebsdaten des Meßwertaufnehmers 1; 6 als auch die bei einer Kalibrierung gewonnenen eigentlichen Korrekturdaten in den Speicher 10 einschreibbar.

<u>Tabelle zu Fig. 2:</u>

| <u>Bausteinbezeichnung</u> | <u>Bausteinspezifikation</u> |
|---|---|
| - Halbleiter | |
| 10 (EEPROM) | NMC9346E |
| T2 (Feldeffekttransistor) | BSS123 |
| T3 (PNP-Transistor) | BC857C |
| Op1 (Komparator) | LM2903M |
| Op2 (Komparator) | LM2903M |
| | |
| D2 (Diode) | BAS40-04 |
| D3 (Diode) | BAS40-04 |
| D4 (Diode) | BAS40-04 |
| | |
| - Widerstände | |
| R 15 | 10k Ohm |
| R 16 | 10k Ohm |
| R 17 | 10k Ohm |
| R 18 | 10k Ohm |
| R 19 | 4,7k Ohm |
| R 20 | 20 Ohm |
| | |
| - Kondensatoren | |
| C 2 (Elektrolyt) | 33µF/16V |
| C 3 (Elektrolyt) | 0,33µF/35V |
| C 4 | 3,3nF |

**Patentansprüche**

1. Meßwertaufnehmer (1; 6) mit einem physikalisch- elektrischen Wandler (2; 8) zur Erfassung einer physikalischen Größe, welche über den physikalisch- elektrischen Wandler (2; 8) in eine äquivalente elektrische Größe umgesetzt und von einer nachgeschalteten, baulich nicht mit dem Meßwertaufnehmer (1; 6) vereinigten, an diesen über elektrische, der Meßwertübertragung und/oder der Energieversorgung des Meßwertaufnehmers (1; 6) dienende Leitungen (Lm1; Lm2) anschließbare Auswerteschaltung (13) in weiterverarbeitbare Größen oder Daten umsetzbar ist, wobei der Meßwertaufnehmer (1; 6) einen nichtflüchtigen Speicherbaustein (5; 10) mit Aufnehmerkennungsdaten des Meßwertaufnehmers umfaßt, welche über die elektrischen Leitungen (Lm1; Lm2) von der Auswerteschaltung (13) ausgelesen und zur Korrektur der vom physikalisch- elektrischen Wandler (2; 8) gelieferten elektrischen Größen herangezogen werden können, **dadurch gekennzeichnet**, daß der Speicherbaustein (5; 10) Bestandteil eines im Meßwertaufnehmer (1; 6) angeordneten Kennungsgebers (4; 7) ist, welcher zur Übertragung der Kennungsdaten an wenigstens zwei der normalerweise zur Meßwertübertragung und/oder der Energieversorgung des Meßwertaufnehmers (1; 6) herangezogene erste und zweite Leitungen (Lm1, Lb) angekoppelt und an eine weitere, der Übermittlung eines Taktsignals (t) von der Auswerteschaltung (13) zum Kennungsgeber (4; 7) dienende dritte Leitung (Lt) angeschlossen ist, wobei das Taktsignal (t) der Synchronisation der Datenübertragung und der Stromversorgung des Kennungsgebers (4; 7) dient.

2. Meßwertaufnehmer nach Anspruch 1, dadurch gekennzeichnet, daß über eine weitere, im Normalfall vorzugsweise zur Energieverorgung und/oder zur Meßwertübertragung des Meßwertaufnehmers (1; 6) herangezogene vierte Leitung (Ls) Steuerinformationen, Adressen und Daten von der Auswerteschaltung (13) zum Kennungsgeber (4; 7) zum Auslesen und/oder zusätzlich zum Einlesen von Aufnehmerkennungsdaten übertragen werden können.

3. Meßwertaufnehmer nach Anspruch 1 oder 2, dadurch gekennzeichnet, daß der Meßwertaufnehmer (1; 6) eine als physikalisch- elektrischen Wandler (2; 8) dienende Brückenschaltung (3; 9) aufweist oder der physikalisch- elektrische Wandler in einer Brückenschaltung (3; 9) verschaltet ist.

4. Meßwertaufnehmer nach Anspruch 1, 2 oder 3, dadurch gekennzeichnet, daß die Ankoppelung des Kennungsgebers (4; 7) an die Leitungen wenigstens über ein, im nichtangesteuerten Zustand gegenüber dem vom Kennungsgeber (4; 7) überbrückten oder zu überbrückenden Teil des Aufnehmers oder physikalisch-elektrischen Wandlers (2; 8) hochohmiges und weitgehend kapazitätsfreies Schaltelement (T1; T2, Op2) erfolgt.

5. Meßwertaufnehmer nach Anspruch 4, dadurch gekennzeichnet, daß das Schaltelement ein Transistor (T1; T2) ist.

6. Meßwertaufnehmer nach Anspruch 5, dadurch gekennzeichnet, daß das Schaltelement ein Feldeffekttransistor (T2) ist.

7. Meßwertaufnehmer nach Anspruch 4, dadurch gekennzeichnet, daß das Schaltelement eine Reihenschaltung aus einer Operationsverstärkerschaltung (Op1, Op2) und einem Feldeffekttransistor (T2) ist.

8. Meßwertaufnehmer nach wenigstens einem der Ansprüche 4 bis 7, dadurch gekennzeichnet, daß das Taktsignal (t) direkt oder über eine Impulsaufbereitungsschaltung (Op1) auf den Speicherbaustein (5; 10) aufgeschaltet und zur Stromversorgung des Kennungsgebers (4; 7) über wenigstens eine Diode (D1; D2, D3) und einen als Siebglied dienenden Kondensator (C1; C2) geführt ist.

9. Meßwertaufnehmer nach wenigstens Anspruch 8, dadurch gekennzeichnet, daß durch das von einem Ausgangssignal des die Korrekturdaten enthaltende Speicherbausteins (5; 10) angesteuerte Schaltelement (T1; Op2) mit dem Datenbitstrom (dkorr) der Aufnehmerkennungsdaten entweder abwechselnd eine Leitung (Lm1) des Meßwertaufnehmers (1; 6) zwischen den Potentialen der Stromversorgung (uv, ub; uvc, gd) hin- und herschaltet oder ein zwischen zwei Leitungen (Lm1, Lb) geschalteter Brückenzweig verstimmt bzw. nicht verstimmt wird.

10. Meßwertaufnehmer nach Anspruch 9, dadurch gekennzeichnet, daß die vierte Leitung (Ls) von der Auswerteschaltung (13) mit einem Dreipegelsignal (dps) beaufschlagt werden kann, wobei ein Steuersignal (cs) für den Speicherbaustein (10) den Steuerinformationen, Adressen und Daten überlagert ist und vom Kennungsgeber (7) mittels einer Trennschaltung (12) wieder in Einzelinformationen aufgetrennt wird.

11. Meßwertaufnehmer nach Anspruch 10, dadurch gekennzeichnet, daß die Aufnehmer- Kennungsdaten neben den Korrekturdaten zum Ausgleich von statischen und/oder dynamischen Wandlungseigenschaften des Meßwertaufnehmers (1; 6) und/oder Teilen der Auswerteschaltung (13), wie z. B. Verstärkungs-, Nullpunktfehlern, Nichtlinearitäten usw., zusätzlich Betriebsdaten für den Meßwertaufnehmer (1; 6) bzw. für den physikalisch- elektrischen Wandler (2; 8) umfassen.

12. Meßwertaufnehmer nach Anspruch 10, dadurch gekennzeichnet, daß der Speicherbaustein (5; 10) ein lösch- und programmierbarer nichtflüchtiger Speicherbaustein mit seriellem Datenausgang (DO) bzw. Dateneingang (DI) ist.

**Claims**

1. Measurement sensor (1; 6) with a physical-electrical transducer (2; 8) for registering a physical value which is converted by the physical-electrical transducer (2; 8) into an equivalent electrical value and can be converted by an evaluation circuit (13) into values or data which can be further processed, which evaluation circuit is connected downstream, is not structurally combined with the measurement sensor (1; 6) and can be connected thereto by electrical conductors (Lm1; Lm2) which serve for the transfer of measurements and/or for the power supply to the measurement sensor (1; 6), wherein the measurement sensor (1; 6) includes a non-volatile storage component (5; 10) with sensor identification data of the measurement sensor which can be read out by the evaluation circuit (13) via the electrical conductors (Lm1; Lm2) and used for the correction of the electrical values supplied by the physical - electrical transducer (2; 8), characterised in that the storage component (5; 10) is part of an identification transmitter (4; 7) which is arranged in the measurement sensor (1; 6) and which for the transfer of identification data is coupled to at least two of the first and second conductors (Lm1, Lb) normally used for the transfer of measurements and/or for the power supply to the measurement sensor (1; 6) and is connected to a further, third conductor (Lt) which serves for the transmission of a clock signal (t) from the evaluation circuit (13) to the identification transmitter (4; 7), the clock signal (t) serving for synchronisation of the data transfer and the current supply of the identification transmitter (4; 7).

2. Measurement sensor according to Claim 1, characterised in that control information, addresses and data can be transferred by means of a further, fourth conductor (Ls), which is preferably used in the normal case for power supply and/or for transfer of measurements of the measurement sensor (1; 6), from the evaluation circuit (13) to the identification transmitter (4; 7) for reading out and/or additionally for reading in of sensor identification data.

3. Measurement sensor according to Claim 1 or 2, characterised in that the measurement sensor (1; 6) has a bridge circuit (3; 9) which serves as the physical-electrical transducer (2; 8) or the physical-electrical transducer is connected in a bridge circuit (3; 9).

4. Measurement sensor according to Claim 1, 2 or 3, characterised in that the identification transmitter (4; 7) is coupled to the conductors at least by a circuit element (T1; T2, Op2) which in the non-controlled state is highly resistive and largely non-capacitive with respect to the part of the sensor or of the physical-electrical transducer (2; 8) which is bridged or to be bridged by the identification transmitter (4; 7).

5. Measurement sensor according to Claim 4, characterised in that the circuit element is a transistor (T1; T2).

6. Measurement sensor according to Claim 5, characterised in that the circuit element is a field-effect transistor (T2).

7. Measurement sensor according to Claim 4, characterised in that the circuit element is a series connection of an operational amplifier circuit (Op1, Op2) and a field effect transistor (T2).

8. Measurement sensor according to at least one of Claims 4 to 7, characterised in that the clock signal (t) is switched to the storage component (5; 10) directly or via a pulse generation circuit (Op1) and for the current supply to the identification transmitter (4; 7) is led via at least one diode (D1; D2, D3) and a capacitor (C1; C2) which serves as a filter element.

9. Measurement sensor according to at least Claim 8, characterised in that by means of the circuit element (T1; Op2), which is controlled by an output signal from the storage component (5; 10) containing the correction data, with the data bit current (dkorr) of the sensor identification data either one conductor (Lm1) of the measurement sensor (1; 6) is alternately switched to and fro between the potentials of the current supply (uv, ub; uvc, gd) or an arm of the bridge connected between two conductors (Lm1, Lb) is detuned or is not detuned.

10. Measurement sensor according to Claim 9, characterised in that the fourth conductor (Ls) can be supplied by the evaluation circuit (13) with a three-level signal (dps), a control signal (cs) for the storage component (10) being superimposed on the control information, addresses and data and being separated again into individual items of information by the identification transmitter (7) by means of a separation circuit (12).

11. Measurement sensor according to Claim 10, characterised in that in addition to the correction data for equalising static and/or dynamic conversion properties of the measurement sensor (1; 6) and/or parts of the evaluation circuit (13), such as for example amplification and zero point errors, non-linearities, etc., the sensor identification data also include operating data for the measurement sensor (1; 6) or for the physical-electrical transducer (2; 8).

12. Measurement sensor according to Claim 10, characterised in that the storage component (5; 10) is an erasable and programmable non-volatile storage component with serial data output (DO) or data input (DI).

**Revendications**

1. Capteur de valeurs de mesure (1; 6), avec un convertisseur physique-électrique (2; 8), pour appréhender une grandeur physique, qui peut être convertie, par l'intermédiaire du convertisseur physique-électrique (2; 8) en une grandeur électrique équivalente et pouvant être convertie, par un circuit d'évaluation (13) monté en aval, non réuni structurellement au capteur ( 1; 6) mais pouvant être raccordé à celui-ci par des lignes électriques (Lm1; Lm2), servant à la transmission des mesures et/ou à l'alimentation électrique du capteur (1; 6), la conversion donnant des grandeurs ou des données pouvant faire l'objet d'un traitement ultérieur, le capteur de valeurs de mesure (1; 6) comprenant un composant mémoire (5; 10) non-volatil, avec des données d'identification du capteur, qui sont lues par le circuit d'évaluation (13), par l'intermédiaire des lignes électriques (Lm1; Lm2) et peuvent être exploitées pour opérer la correction des grandeurs électriques fournies par le convertisseur physique-électrique (2; 8), caractérisé en ce que le composant mémoire (5; 10) fait partie d'un transducteur d'identification (4; 7) disposé dans le capteur (1; 6), qui est raccordé, en vue de la transmission des données d'identification à au moins deux des première et deuxième lignes (Lm1; Lb) normalement sollicitées pour la transmission des valeurs de mesure et/ou pour l'alimentation en énergie du capteur (1; 6) et à une troisième ligne (Lt), servant à la transmission d'un signal de cadencement (t) depuis le circuit d'évaluation ( 13) vers le transducteur d'identification (4; 7), le signal de cadencement (t) servant à la synchronisation de la transmission de données et à l'alimentation électrique du transducteur d'identification (4; 7).

2. Capteur selon la revendication 1, caractérisé en ce que des informations de commande, des adresses et des données allant du circuit d'évaluation (13) au transducteur d'identification (4; 7), pour opérer la lecture et/ou en plus l'écriture de données d'identification d'enregistrement, peuvent être transmises par l'intermédiaire d'une quatrième ligne supplémentaire (Ls), sollicitée en cas normal de préférence pour l'alimentation en énergie et/ou pour la transmission des valeurs de mesure du capteur (1; 6).

3. Capteur selon la revendication 1 ou 2, caractérisé en ce que le capteur (1; 6) présente un circuit en pont (3; 9) servant de convertisseur physique-électrique (2; 8) ou bien le convertisseur physique-électrique est câblé en circuit en pont (3; 9).

4. Capteur selon la revendication 1, 2 ou 3, caractérisé en ce que le couplage du transducteur d'identification (4; 7) aux lignes s'effectue au moins par l'intermédiaire d'un élément de commutation (T1; T2, Op2) à résistance élevée ou largement non capacitif, dans la partie court-circuitée à l'état non commandé du capteur ou du convertisseur physique-électrique (2; 8), ou à court-circuiter par rapport au transducteur d'identification (4; 7).

5. Capteur selon la revendication 4, caractérisé en ce que l'élément de commutation est un transistor (T1; T2).

6. Capteur selon la revendication 5, caractérisé en ce que l'élément de commutation est un transistor à effet de champ (T2).

**7.** Capteur selon la revendication 4, caractérisé en ce que l'élément de commutation est un branchement en série composé d'un circuit amplificateur opérationnel (Op1, Op2) et d'un transistor à effet de champ (T2).

**8.** Capteur selon au moins l'une des revendications 4 à 7, caractérisé en ce que le signal de cadencement (t) est pris directement ou par l'intermédiaire d'un circuit de préparation d'impulsion (Op1), sur le composant mémoire (5; 10) et guidé, pour l'alimentation électrique du transducteur d'identification (4; 7), par l'intermédiaire d'au moins une diode (D&; D2; D3) et d'un condensateur (C1; C2) servant d'élément filtrant.

**9.** Capteur selon au moins la revendication 8, caractérisé en ce que l'élément de commutation (T1; Op2) commandé par un signal de sortie du composant mémoire (5; 10) contenant les données de correction est branché avec le courant de bits de données (dkorr) des données d'identification de capteur, alternativement, soit à une ligne (Lm1) du capteur (1; 6) entre les potentiels d'alimentation électrique (uv, ub; uvc, gd), soit sur une ramification de pont branchée entre deux lignes (Lm1, Lb), selon qu'il y a accord ou non.

**10.** Capteur selon la revendication 9, caractérisé en ce que la quatrième ligne (Ls) venant du circuit d'évaluation (13) peut être sollicitée par un signal à trois niveaux, un signal de commande (cs) pour le composant mémoire (10) étant superposé aux informations de commande, aux adresses et aux données, et séparé par le transducteur d'identification (7), au moyen d'un circuit de séparation (12), pour redonner les informations spécifiques.

**11.** Capteur selon la revendication 10, caractérisé en ce qu'outre les données de correction destinées à la compensation de propriétés statiques et/ou dynamiques de conversion du capteur (1; 6) et/ou de parties du circuit d'évaluation (13), telles que par exemple les manques de point zéro, les non-linéarités, etc., les données d'identification de capteur comprennent en outre des données de fonctionnement destinées au capteur (1; 6), ou au convertisseur physique-électrique (2; 8).

**12.** Capteur selon la revendication 10, caractérisé en ce que le composant mémoire (5; 10) est un composant mémoire effaçable et programmable, non-volatil, avec une sortie série des données (DO) ou une entrée série des données (DI).

FIG.1

EP 0 324 067 B1

FIG.2

FIG.3

EP 0 324 067 B1